# EUROPÄISCHE PATENTSCHRIFT

(11) **EP 3 577 695 B1**
(45) Veröffentlichungstag und Bekanntmachung des Hinweises auf die Patenterteilung: **14.07.2021**
(21) Anmeldenummer: 18713574.4
(22) Anmeldetag: 06.03.2018
(51) Int. Cl.: H01L 31/043, H01L 31/02, H01L 51/42, H02S 50/10, H01L 25/04

(54) **PHOTOVOLTAIKEINRICHTUNG**
PHOTOVOLTAIC DEVICE
DISPOSITIF PHOTOVOLTAÏQUE

(30) Priorität: 08.03.2017 DE 102017203809; 31.03.2017 DE 102017205524
(43) Veröffentlichungstag der Anmeldung: 11.12.2019
(73) Patentinhaber: Siemens Energy Global GmbH & Co. KG, 81739 München (DE)
(72) Erfinder: FLEISCHER, Maximilian, 85635 Höhenkirchen (DE); SCHNETTLER, Armin, 52076 Aachen (DE)
(86) Internationale Anmeldenummer: PCT/EP2018/055499
(87) Internationale Veröffentlichungsnummer: WO 2018/162496

(56) Entgegenhaltungen:
- WO-A2-03/098703
- WO-A2-2010/000855
- WO-A2-2011/154108
- US-A1- 2010 052 425
- US-B1- 8 569 613
- ZHANG DONG ET AL: "Combination of Advanced Optical Modelling with Electrical Simulation for Performance Evaluation of Practical 4-terminal Perovskite/c-Si Tandem Modules", ENERGY PROCEDIA, ELSEVIER, NL, Bd. 92, 23. September 2016 (2016-09-23), Seiten 669-677, XP029715880, ISSN: 1876-6102, DOI: 10.1016/J.EGYPRO.2016.07.039

## Beschreibung

Die Erfindung betrifft eine Photovoltaikeinrichtung mit zwei oder auch mehr separaten Solarzellen.

Solare Stromerzeugung mit den Mitteln der Photovoltaik (PV) trägt aus umweltpolitischen und zunehmend auch wirtschaftlichen Gründen bspw. in Mitteleuropa einen stark steigenden Anteil zur Elektrizitätsproduktion bei. Diese regenerative Energiequelle muss jedoch, auch und insbesondere im Vergleich mit den konventionellen Energiequellen, wettbewerbsfähig sein, weswegen angestrebt wird, die PV-Stromgestehungskosten auch in Regionen mit mäßig intensiver Sonneneinstrahlung wie bspw. Deutschland unter diejenigen von konventioneller, insbesondere fossiler Energieerzeugung zu treiben.

Die Kosten einer PV-Anlage werden zu wesentlichen Teilen durch Systemkosten bspw. für das Gesamtpaneel, die Verkabelung, die Leistungselektronik und sonstige Baukosten bestimmt. Auch wenn seit einigen Jahren sogenannte perowskitische Materialien wie z.B. CH3NH3PbI3 (oder allgemeiner (CH3NH3)MX3-xYx (mit M=Pb oder Sn sowie X,Y=I, Br oder Cl)), die aufgrund ihrer optoelektronischen Eigenschaften eine hocheffiziente Umwandlung von elektromagnetischer Strahlungsenergie in elektrische Energie erlauben, vermehrt an Bedeutung gewinnen und einen die Betriebskosten senkenden Effekt versprechen, ist die alleinige Verwendung derartiger neuer, kostengünstiger Solarzellen noch nicht ausreichend. Es ist dagegen notwendig, die Effizienz der Solarzellen weiter zu erhöhen.

Ein Ansatz zur Effizienzsteigerung besteht in der Verwendung sogenannter Tandem-PV-Zellgruppen, bei denen zwei oder sogar mehr lichtsensitive PV-Zellen bzw. Schichten übereinander angeordnet sind. Derartige Ansätze werden bspw. in der US8569613B1 bzw. in der WO2010/000855A1 mit sogar mehr als zwei photosensitiven Schichten adressiert. Die verschiedenen Zellen unterscheiden sich dabei idealerweise in ihrer spektralen Empfindlichkeit, d.h. unterschiedliche Zellen weisen ihre jeweilige Maximaleffizienz für unterschiedliche Spektralbereiche des Sonnenlichts auf. Dies bewirkt, dass die Tandem-Zellgruppe als Ganzes eine hohe Effizienz für einen breiteren Spektralbereich bietet.

Eine derartige Tandem-Zellgruppe kann bspw. eine klassische siliziumbasierte PV-Zelle aufweisen, auf der eine weitere, bspw. perowskitbasierte PV-Zelle aufgebracht ist. Perowskitische Materialien weisen einen größeren Bandabstand auf als siliziumbasierte Materialien, weswegen die perowskitbasierte PV-Zelle einen höheren Absorbtionsanteil im blauen bzw. kurzwelligen Spektralbereich hat und längerwelliges Licht durchlässt. Die siliziumbasierte PV-Zelle absorbiert stärker im längerwelligen Spektralbereich, so dass das von der Perowskitzelle bzw. -schicht durchgelassene Licht bzw. zumindest ein Teil davon von der Siliziumzelle absorbiert wird.

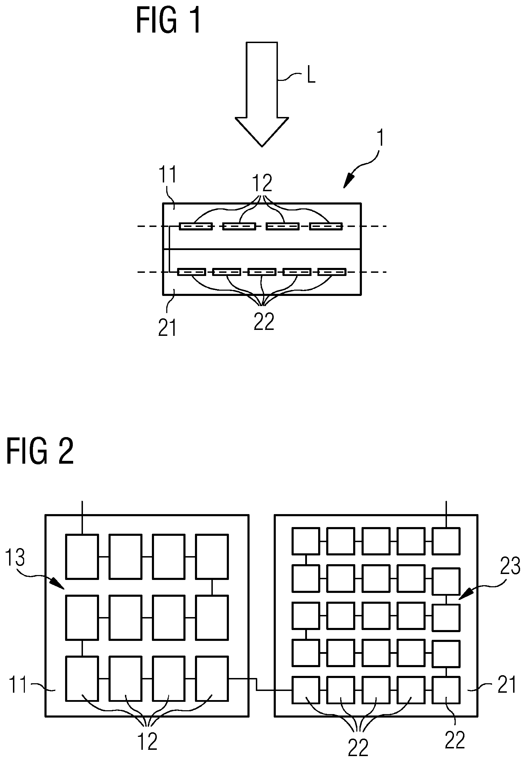

Die FIG 1 zeigt eine Seitenansicht einer solchen bekannten Tandem-PV-Zellgruppe 1. Die obere, d.h. der nicht dargestellten Lichtquelle bzw. der Sonne zugewandte Zelle 11 der Tandem-Zellgruppe 1 ist eine PV-Zelle aus einem ersten Material mit maximaler Effizienz in einem ersten Spektralbereich S1. Die untere Zelle 21 ist eine PV-Zelle aus einem zweiten Material mit maximaler Effizienz in einem zweiten Spektralbereich S2, wobei die Spektralbereiche S1, S2 sowie auch die Materialien unterschiedlich sind. Grundsätzlich arbeiten derartige Tandem-Zellgruppen nach dem Konzept, dass der bei Lichteinfall L erzeugte elektrische Strom I nacheinander durch beiden Zellen 11, 21 fliest, d.h. die Zellen 11, 21 sind elektrisch in Reihe geschaltet. Hierbei tritt jedoch das Problem auf, dass für den Fall, dass in den beiden Zellen 11, 21 signifikant verschieden große Ströme generiert werden, diejenige Zelle 11, 21, in der ein geringer Strom generiert wird, von dem großen Strom der anderen Zelle 21, 11 durchflossen wird, was zu einer Beschädigung führen kann. Weiterhin gilt, dass idealerweise beide Zellen 11, 21 pro lichtsensitiver Fläche den gleichen Strom liefern. Aufgrund der Andersartigkeit der in den verschiedenen Zellen 11, 21 eingesetzten Materialien ist dies jedoch im Allgemeinen nicht der Fall. Dies wirkt sich darin aus, dass die Effizienz bzw. der Wirkungsgrad der Tandem-PV-Zellgruppe 1 als Ganzes deutlich geringer ist als theoretisch machbar bzw. aufgrund der Einzeleffizienzen zu erwarten wäre.

Dieses Problem lässt sich grundsätzlich über einen als "current matching" bezeichneten Ansatz dadurch lösen, dass die einzelnen Zellen 11, 21 derart ausgebildet sind, dass sie gleich große elektrische Ströme liefern. Um dies zu erreichen können die lichtsensitiven und bei entsprechender Beleuchtung den Strom generierenden Areale 12, 22 der beiden PV-Zellen 11, 21 aufeinander abgestimmt sein, wobei die Areale 12 in der ersten Zelle 11 aus dem ersten Material und die Areale 22 in der zweiten Zelle 21 aus dem zweiten Material bestehen. Dabei wird davon ausgegangen, dass der in einem Areal 12, 22 produzierte elektrische Strom proportional zur Fläche des jeweiligen Areals 12, 22 ist. Dementsprechend können die Flächen sowie die Anzahlen der Areale 12, 22, wie in der FIG 2 angedeutet, derart unterschiedlich gewählt werden, dass die beiden Zellen 11, 21 letztlich gleich große elektrische Ströme liefern. Die hierzu zu wählenden Größen und Anzahlen der Flächen hängen dabei von den jeweiligen Materialien ab. Die unterschiedlich geformten, übereinander liegenden Strukturen stellen sich in diesem Zusammenhang jedoch als technologisch problematisch heraus.

Die FIG 2 zeigt eine Sicht in γ-Richtung auf die in der FIG 1 mit den gestrichelten Linien angedeuteten Ebenen, wobei die Darstellung in FIG 2 so gewählt ist, als wäre die Zelle 1 der FIG 1 derart auseinander geklappt, dass die beiden Schichten 11, 21 nun nebeneinander liegen. Es wird verdeutlicht, dass die Flächen der Areale 12 der ersten Zelle 11 größer sind als die Flächen der Areale 22 der zweiten Zelle 21. Dabei sind der Übersichtlichkeit wegen nur einige wenige der jeweiligen Areale 12, 22 mit Bezugszeichen versehen. Für jede PV-Zelle 11, 21 gilt, dass die Areale 12, 22 der jeweiligen Zelle 11, 21 zu einer jeweiligen Arealgruppe 13, 23 in Reihe geschaltet sind. Weiterhin sind auch die beiden Arealgruppen 13, 23 elektrisch hintereinander, d.h. in Reihe geschaltet.

Das Konzept der Anpassung der Flächen der lichtsensitiven Areale 12, 22 stellt zwar theoretisch eine Lösung des genannten Problems dar. In der Praxis stellt sich jedoch heraus, dass der Wirkungsgrad der so aufgebauten Tandem-PV-Zellgruppe 1 im Durchschnitt weiterhin unter dem theoretisch machbaren Wert bleit. Dies hängt damit zusammen, dass die Lichtintensitäten in der Praxis zeitlich nicht konstant sind, sondern im Tageverlauf mehr oder weniger starken Schwankungen unterliegen, was sich unterschiedlich stark in den von den unterschiedlichen Zellen generierten Spannungen bzw. Strömen niederschlägt. So arbeiten siliziumbasierte PV-Zellen (Si-Zellen) bei hohen Lichtintensitäten, d.h. bspw. bei vollem Sonnenlicht, mit besonders hohem Wirkungsgrad. Der Wirkungsgrad derartiger Si-Zellen fällt jedoch bei schwächerem Licht unter den Wirkungsgrad von bspw. organischen PV-Zellen, welche besonders bei diffusem und schwachem Licht vergleichsweise hohe Wirkungsgrade aufweisen. Außerdem ist davon auszugehen, dass die unterschiedlichen Zellen unterschiedlichen Alterungseffekten und Temperaturgängen unterliegen. Der in FIG 2 dargestellte Ansatz mit angepassten Flächen der lichtsensitiven Areale ist also letztlich nicht zielführend.

Es ist daher eine Aufgabe der vorliegenden Erfindung, einen alternativen Ansatz für eine hocheffiziente Photovoltaikzelle anzugeben.

Diese Aufgabe wird durch die in Anspruch 1 beschriebene PV-Einrichtung sowie durch das in Anspruch 10 erläuterte Betriebsverfahren gelöst. Die Unteransprüche beschreiben vorteilhafte Ausgestaltungen.

Eine erfindungsgemäße PV-Einrichtung weist eine Multi-PV-Zellgruppe mit zumindest einer ersten PV-Zelle eines ersten Zelltyps und einer zweiten PV-Zelle eines zweiten Zelltyps auf, wobei sich der erste und der zweite Zelltyp voneinander unterscheiden und wobei jede der PV-Zellen bei Lichteinfall auf die jeweilige PV-Zelle eine elektrische Zellspannung U1, U2 bereitstellt. Desweiteren ist eine Leistungselektronik vorgesehen mit einer separaten ersten Leistungselektronikeinheit, die der ersten PV-Zelle zugeordnet ist, und einer separaten zweiten Leistungselektronikeinheit, die der zweiten PV-Zelle zugeordnet ist. Die in der jeweiligen PV-Zelle generierte elektrische Zellspannung U1, U2 und ein entsprechender Stromertrag I1, I2 sind der jeweiligen PV-Zelle zugeordneten separaten Leistungselektronikeinheit zuführbar, bspw. über entsprechende elektrische Verbindungen. Weiterhin weist die PV-Einrichtung eine Regeleinrichtung zum Regeln der Leistungselektronik auf. Die erste und die zweite Leistungselektronikeinheit sind nun mit Hilfe der Regeleinrichtung unabhängig voneinander derart betreibbar, dass jedes PV-Subsystem, welches jeweils eine der PV-Zellen und die der jeweiligen PV-Zelle zugeordnete Leistungselektronikeinheit aufweist, an seinem optimalen Arbeitspunkt arbeitet. Mit anderen Worten weist die PV-Einrichtung zumindest ein erstes und ein zweites PV-Subsystem auf, wobei das erste PV-Subsystem die erste PV-Zelle und die erste Leistungselektronikeinheit aufweist und das zweite PV-Subsystem die zweite PV-Zelle und die zweite Leistungselektronikeinheit aufweist.

Für das Design der hier vorgeschlagenen hocheffizienten Multi-PV-Zellgruppe, die ihre hohe Effizienz auch bei variabler Beleuchtungsstärke nicht verliert, kann auf den oben beschriebenen "current matching"-Ansatz verzichtet werden. Die Tandem-PV-Zellgruppe weist zwei galvanisch getrennte PV-Zellen auf, die weder in Reihe noch in irgendeiner anderen Weise direkt elektrisch verschaltet sind. Vielmehr werden die von den PV-Zellen der Zellgruppe bei Beleuchtung generierten elektrischen Spannungen sowie in der Folge auch die entsprechenden Ströme jeweils einer separaten Leistungselektronikeinheit zugeführt. Durch die Verwendung individueller Leistungselektronikeinheiten für die verschiedenen PV-Zellen wird erreicht, dass jede PV-Zelle am optimalen Arbeitspunkt betrieben werden kann.

Die Regeleinrichtung ist ausgebildet, um beim Betreiben der Leistungselektronikeinheit eines jeden PV-Subsystems die jeweilige Leistungselektronikeinheit derart zu regeln, dass ein Produkt aus dem Stromertrag I1, I2 und der Zellspannung U1, U2 der der jeweiligen Leistungselektronikeinheit zugeordneten PV-Zelle maximal ist. Dabei wird hier und im Folgenden natürlich davon ausgegangen, dass der Ausdruck, dass das Produkt "maximal" sein soll, nicht zwangsläufig zu jedem Zeitpunkt den exakten Punkt meint bzw. meinen kann, bei dem das genannte Produkt das absolute Maximum erreicht. Dies ist auch insofern technisch nicht realisierbar, als dass die der Regeleinrichtung zugeführten Werte in der Praxis kontinuierlich in gewissem Rahmen variieren, so dass ein theoretisch zu einem Zeitpunkt T1 tatsächlich maximaler Wert zum nächsten Zeitpunkt T2 schon wieder nicht mehr der theoretisch maximale Wert ist. Dementsprechend meint der Ausdruck dass das jeweilige Produkt "maximal" sein soll, dass im Rahmen der Regelung jeweils dahingehend geregelt wird, dass die Leistungselektronikeinheiten jeweils stets derart angepasst werden, dass sich das jeweilige Strom-Spannungs-Produkt zu dem momentanen, theoretisch möglichen Maximum hin verändert. Faktisch wird also derart geregelt, dass das Strom-Spannungs-Produkt über einen bestimmten Zeitraum betrachtet nicht kleiner wird. D.h. das Produkt soll größer werden oder kann für den Fall, dass das theoretisch mögliche Maximum bereits erreicht ist, konstant bleiben.

Die Regeleinrichtung kann hierzu derart arbeiten, dass beim Regeln der jeweiligen Leistungselektronikeinheit ein Eingangswiderstand der jeweiligen Leistungselektronikeinheit derart anpassbar ist, dass das Produkt aus dem Stromertrag I1, I2 und der Zellspannung U1, U2 der der jeweiligen Leistungselektronikeinheit zugeordneten PV-Zelle maximal ist. Insbesondere ist die Regeleinrichtung ausgebildet, um die Leistungselektronikeinheiten unabhängig voneinander zu regeln. Hierzu kann die Regeleinrichtung bspw. eine der Anzahl der PV-Subsysteme entsprechende Zahl von Reglern aufweisen. Diese Regler können bspw. als sog. PID-Regler ausgebildet sein.

Alternativ oder zusätzlich weist die PV-Einrichtung eine Sensoreinrichtung auf mit einer Einrichtung zur Ermittlung von Temperaturen der PV-Zellen und/oder zur Ermittlung einer Umgebungstemperatur der Multi-PV-Zellgruppe, wobei ein oder mehrere die Temperaturen und/oder die Umgebungstemperatur beschreibende Parameter der Regeleinrichtung als Eingangsgröße zugeführt werden. Zusätzlich oder alternativ kann die Sensoreinrichtung eine Einrichtung zur Ermittlung einer auf die PV-Einrichtung, insbesondere auf die erste PV-Zelle, fallenden Lichtstärke aufweisen, wobei ein die Lichtstärke beschreibender Parameter der Regeleinrichtung als Eingangsgröße zugeführt wird. Ebenfalls zusätzlich oder alternativ kann die Sensoreinrichtung eine Einrichtung zur Ermittlung eines Spektrums eines auf die PV-Einrichtung, insbesondere auf die erste PV-Zelle, fallenden Lichts aufweisen, wobei ein das Spektrum beschreibender Parameter der Regeleinrichtung als Eingangsgröße zugeführt wird. Die Regeleinrichtung ist nun ausgebildet, um die Leistungselektronikeinheiten basierend auf der oder den ihr zugeführten Eingangsgrößen zu regeln.

Dabei ist die Regeleinrichtung insbesondere ausgebildet, um die Regelung, insbesondere basierend auf Lookup-Tabellen oder modellbasiert, derart auszuführen, dass in Abhängigkeit von der oder den Eingangsgrößen für jede Leistungselektronikeinheit derjenige Eingangswiderstand bestimmt und eingestellt wird, dass das Produkt aus dem Stromertrag I und der Zellspannung U der der jeweiligen Leistungselektronikeinheit zugeordneten PV-Zelle maximal ist.

Vorzugsweise sind der erste und der zweite Zelltyp derart ausgewählt, dass ihre PCE-Maxima (PCE=Power Conversion Efficiency) in unterschiedlichen Spektralbereichen liegen.

Insbesondere ist für die zweite PV-Zelle ein Zelltyp ausgewählt, dessen PCE-Maximum in einem Spektralbereich liegt, für den die erste PV-Zelle im Wesentlichen transparent ist. "Im Wesentlichen transparent" soll dabei bedeuten, dass die erste PV-Zelle diesen speziellen Spektralbereich im Vergleich zu anderen Spektralbereichen deutlich weniger absorbiert. Es muss natürlich davon ausgegangen werden, dass die erste PV-Zelle grundsätzlich in jedem für diese Anwendung relevanten Spektralbereich einen gewissen Absorptionsgrad aufweist, jedoch kann ebenso davon ausgegangen werden, dass der Absorptionsgrad in bestimmten Bereichen des Lichtspektrums vergleichsweise gering und damit "im Wesentlichen transparent" ist.

Bspw. kann die erste PV-Zelle eine perowskitbasierte PV-Zelle und/oder die zweite PV-Zelle eine siliziumbasierte PV-Zelle sein.

In diesem Fall ist die Regeleinrichtung ausgebildet, um die der ersten, perowskitbasierten PV-Zelle zugeordnete Leistungselektronikeinheit derart zu regeln, dass eine Hysterese von Ausgangsgrößen der ersten PV-Zelle kompensiert werden. Diese Kompensation wird durch entsprechende Anpassung der Betriebsparameter des Reglers, bspw. PID-Parameter, erreicht.

Die Regeleinrichtung ist desweiteren ausgebildet, um die Regelung der Leistungselektronikeinheiten derart auszuführen, dass eine Alterung einer jeweiligen PV-Zelle und/oder eine Verschmutzung der Multi-PV-Zellgruppe bzw. der einzelnen PV-Zellen kompensiert werden. Dabei wird wiederum die Optimierung des Produkts aus dem Stromertrag I und der Zellspannung U der der jeweiligen Leistungselektronikeinheit zugeordneten PV-Zelle angestrebt, wobei auch hier die Eingangswiderstände der Leistungselektronikeinheiten unabhängig voneinander eingestellt werden.

In einem erfindungsgemäßen Verfahren zum Betreiben einer derartigen PV-Einrichtung mit Multi-PV-Zellgruppe, Leistungselektronik, Regeleinrichtung der eingangs genannten Arten, werden die erste und die zweite Leistungselektronikeinheit mit Hilfe der Regeleinrichtung unabhängig voneinander derart betrieben, dass jedes PV-Subsystem, welches jeweils eine der PV-Zellen und die ihr zugeordneten Leistungselektronikeinheit aufweist, an seinem optimalen Arbeitspunkt arbeitet.

Beim Betreiben der Leistungselektronikeinheit eines jeden PV-Subsystems wird die jeweilige Leistungselektronikeinheit derart geregelt, dass ein Produkt aus dem Stromertrag I1, I2 und der Zellspannung U1, U2 der der jeweiligen Leistungselektronikeinheit zugeordneten PV-Zelle maximal ist.

Beim Regeln der jeweiligen Leistungselektronikeinheit ein Eingangswiderstand wird der jeweiligen Leistungselektronikeinheit derart angepasst, dass das Produkt aus dem Stromertrag I1, I2 und der Zellspannung U1, U2 der der jeweiligen Leistungselektronikeinheit zugeordneten PV-Zelle maximal ist.

Vorzugsweise regelt die Regeleinrichtung die Leistungselektronikeinheiten unabhängig voneinander.

Wiederum für den Fall, dass die PV-Einrichtung eine Sensoreinrichtung der oben genannten Art aufweist, werden die Leistungselektronikeinheiten basierend auf der oder den der Regeleinrichtung zugeführten Eingangsgrößen geregelt.

Dabei wird die Regelung, insbesondere basierend auf Lookup-Tabellen oder modellbasiert, derart ausgeführt, dass in Abhängigkeit von der oder den Eingangsgrößen für jede Leistungselektronikeinheit derjenige Eingangswiderstand bestimmt und eingestellt wird, mit dem das Produkt aus dem Stromertrag I und der Zellspannung U der der jeweiligen Leistungselektronikeinheit zugeordneten PV-Zelle maximal ist. Dabei kann in der Lookup-Tabelle auch eine Alterungskurve einer Zelllage hinterlegt sein.

Für jede Leistungselektronik werden also die Spannungs- und Stromniveaus derart angepasst, dass ein maximaler Energieertrag der jeweiligen PV-Zelle erreicht wird, d.h. jede PV-Zelle arbeitet mit der ihr zugeordneten Leistungselektronik an ihrem optimalen Arbeitspunkt.

Die Anpassung kann bspw. durch Regelung des Eingangswiderstands der jeweiligen Leistungselektronik erfolgen, wobei sich die Regelung des Eingangswiderstands auf den Stromertrag I bei von der Beleuchtung abhängigen Zellspannung U der mit dieser Leistungselektronik verbundenen PV-Zelle auswirkt. Das Produkt der von der PV-Zelle bei Beleuchtung generierten Spannung U mit dem entsprechenden Strom I beschreibt den Energieertrag der PV-Zelle.

Durch die mit Hilfe der getrennten Leistungselektronikeinheiten mögliche individuelle Anpassung ann dies mit deutlich geringeren Verlusten gegenüber der Situation mit elektrisch fest gekoppelten PV-Zellen erfolgen, bei der in der Praxis immer ein Zelltyp suboptimal betrieben wird. Das Konzept beruht also auf dem Weggang vom bisher allgegenwärtigen Paradigma der klassischen Reihenschaltung von Einzelzellen einer Multi-PV-Zellgruppe mit einer gemeinsamen Elektronik hin zum parallelisierten Konzept der Einzel-PV-Zellen, bei dem mit separaten Primärelektroniken beide PV-Zellen unter optimalen Bedingungen betrieben werden und die Nutzenergien auf der Ebene der Elektronik addiert werden können.

Durch diesen Ansatz werden die erläuterten Nachteile der unterschiedlichen Stromtragfähigkeiten unterschiedlicher PV-Zellen eliminiert. Zugleich kann jede PV-Zelle der Zellgruppe bei ihrem optimalen Arbeitspunkt betrieben werden, d.h. dadurch, dass für beide PV-Zellen separate Leistungselektroniken vorgesehen sind, können sie beide kontinuierlich am jeweils optimalen Arbeitspunkt betrieben werden.

Der vorgestellte Ansatz löst zudem einen anderen problematischen Aspekt von Multi-PV-Zellgruppen: PV-Zellen unterliegen im Allgemeinen einem Alterungsprozess. Bei der klassischen Reihenschaltung der Zellen der Zellgruppe gemäß dem Stand der Technik hat dies unausweichlich eine Verstimmung der Abstimmung der Einzelzellen zur Folge. Dieser Effekt spielt bei dem erfindungsgemäßen Ansatz keine Rolle mehr.

Zusätzlich ergeben sich durch den Verzicht auf das "current matching" weitgehende Designfreiheiten für die Einzelzellen. So können bspw. die Flächen beider PV-Zellen der Zellgruppe weitestgehend frei gewählt werden, d.h. es kann jeweils eine Zellfläche verwendet werden, die zur jeweiligen Technologie optimal passt. Ebenso können natürlich gleichgroße übereinanderliegende PV-Zellen zum Einsatz kommen. Dies ist vor allem bei der Verwendung von Dünnfilmsystemen für die einzelnen PV-Zellen vorteilhaft, bei der Schichtgrenzen und die korrespondierende Stufe oftmals technologische Hürden für darauf abgeschiedene Schichten darstellen.

Durch die oben beschriebene Auftrennung der Zellgruppe in Einzelzellen und insbesondere die Verwendung separater, unabhängiger Leistungselektroniken können auf die jeweilige PV-Zelle optimierte Elektroniken verwendet werden. Erfindungsgemäß können aufgrund der separaten Elektroniken neben der Anpassung an den jeweiligen optimalen Arbeitspunkt noch andere problematische Themen adressiert werden, die speziell bei den neuartigen perowskitbasierten PV-Zellen in Erscheinung treten. Bspw. zeigt sich bei einer perowskitbasierten Zelle eine Hysterese der Ausgangskennwerte der Zelle, d.h. die Ausgangscharakteristik der Zelle ändert sich in Abhängigkeit vom vorangegangenen Betrieb der Zelle. Dies lässt sich bspw. über eine Anpassung der PID-Parameter eines in der Leistungselektronik der perowskitbasierten PV-Zelle integrierten PID-Reglers kompensieren.

Desweiteren zeigen perowskitbasierte PV-Zellen im Unterschied zu konventionellen PV-Zellen oftmals einen sog. Einlaufeffekt, der darin besteht, dass die maximale Effizienz der Zelle, welche häufig als "Power Conversion Efficiency" (PCE) bezeichnet wird, bei gleichbleibender Beleuchtung erst nach einer gewissen Verzögerungszeit nach Inbetriebnahme der Zelle erreicht wird. Im Unterschied zur perowskitbasierten Zelle wird die PCE einer siliziumbasierten PV-Zelle quasi unmittelbar nach Inbetriebnahme erreicht. Wieder aufgrund der getrennten Leistungselektronikeinheiten und der individuellen Regelungen der unterschiedlichen PV-Subsysteme können beide Subsysteme am optimalen Arbeitspunkt betrieben werden. Der Energieertrag der perowskitbasierten Zelle ist zwar während der Auswirkungen des Einlaufeffekts gegenüber dem Ertrag der anderen Zelle reduziert, aber wegen der Möglichkeit der individuellen Regelung nichtsdestotrotz für die bestehenden Verhältnisse optimal.

Das Konzept ist nicht nur anwendbar bei der Kombination von perowskitbasierten mit siliziumbasierten Zellen, sondern grundsätzlich auf beliebige Kombinationen mit anderen PV-Zelltypen wie bspw. den Dünnschichtsolarzellen oder mit III/V-Halbleiterzellen.

Weitere Vorteile und Ausführungsformen ergeben sich aus den Zeichnungen und der entsprechenden Beschreibung.

Im Folgenden werden die Erfindung und beispielhafte Ausführungsformen anhand von Zeichnungen näher erläutert. Dort werden gleiche Komponenten in verschiedenen Figuren durch gleiche Bezugszeichen gekennzeichnet.

Es zeigen:
- FIG 1: eine Tandem-PV-Zellgruppe nach dem Stand der Technik,
- FIG 2: Querschnitte der Tandem-PV-Zellgruppe nach dem Stand der Technik,
- FIG 3: eine erfindungsgemäße PV-Einrichtung,
- FIG 4: einen Zusammenhang zwischen Stromertrag I und Zellspannung U bei einer typischen PV-Zelle,
- FIG 5: eine erfindungsgemäße PV-Einrichtung in einer ersten Abwandlung,
- FIG 6: eine erfindungsgemäße PV-Einrichtung in einer zweiten Abwandlung.

Gleiche Bezugszeichen in verschiedenen Figuren kennzeichnen gleiche Komponenten.

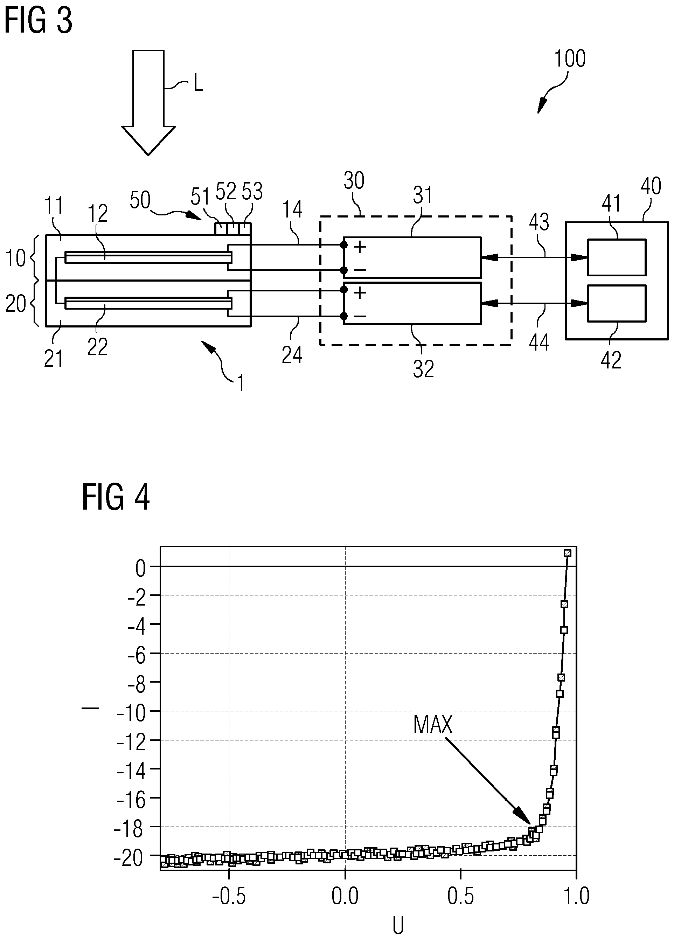

Die FIG 3 zeigt eine PV-Einrichtung 100 mit einer Multi-PV-Zellgruppe 1, welche eine erste PV-Zelle 11 eines ersten Zelltyps, d.h. mit einem oder mehreren ersten lichtsensitiven Arealen 12 aus einem ersten Material, welche bei Beleuchtung einen elektrische Spannung U1 bereitstellen, sowie eine zweite PV-Zelle 21 eines zweiten Zelltyps, d.h. mit einem oder mehreren zweiten (nicht dargestellten) lichtsensitiven Arealen 22 aus einem zweiten Material, welche ebenfalls bei Beleuchtung eine elektrische Spannung U2 bereitstellen, aufweist. Bei der zwei PV-Zellen 11, 21 aufweisenden Multi-PV-Zellgruppe 1 handelt es sich demnach um eine Tandem-PV-Zellgruppe. Im Folgenden wird der Einfachheit halber in der Regel der Ausdruck verwendet, dass die jeweilige PV-Zelle eine Spannung generiert (oder ähnlich), womit jedoch gemeint ist, dass diese Spannungen von den jeweiligen lichtsensitiven Arealen der Zellen generiert werden.

Die Zellgruppe 1 wird im Betrieb derart angeordnet, dass die erste PV-Zelle 11 einer Lichtquelle, bspw. der Sonne, zugewandt ist. Das von der Lichtquelle abgestrahlte und auf die Zellgruppe 1 fallende Licht L trifft also zunächst auf die erste PV-Zelle 11, was in bekannter Weise dazu führt, dass die erste PV-Zelle 11 bzw. deren lichtsensitive Areale 12 aus dem ersten Material die erste elektrische Zellspannung U1 generiert. Nach Durchqueren der ersten PV-Zelle 11 fällt das entsprechende Restlicht auf die zweite PV-Zelle 21, was ebenfalls in bekannter Weise dazu führt, dass die zweite PV-Zelle 21 bzw. deren lichtsensitive Areale 22 aus dem zweiten Material eine zweite elektrische Zellspannung U2 generiert.

Vorteilhafterweise sind die beiden Zelltypen derart gewählt, dass die maximale Effizienz der verschiedenen Zellen 11, 21, welche auch als "Power Conversion Efficiency" (PCE) bezeichnet wird, in unterschiedlichen Spektralbereichen liegen. Insbesondere ist für die zweite PV-Zelle 21 ein Zelltyp ausgewählt, dessen PCE-Maximum in einem Spektralbereich liegt, für den die erste PV-Zelle 11 im Wesentlichen transparent ist. "Im Wesentlichen transparent" soll dabei bedeuten, dass die erste PV-Zelle 11 diesen speziellen Spektralbereich im Vergleich zu anderen Spektralbereichen deutlich weniger absorbiert. Es muss natürlich davon ausgegangen werden, dass die erste PV-Zelle 11 grundsätzlich in jedem für diese Anwendung relevanten Spektralbereich einen gewissen Absorptionsgrad aufweist, jedoch kann ebenso davon ausgegangen werden, dass der Absorptionsgrad in bestimmten Bereichen des Lichtspektrums vergleichsweise gering und die Zelle 11 damit "im Wesentlichen transparent" für diesen Spektralbereich ist.

Im gezeigten Beispiel ist die erste PV-Zelle 11 eine perowskitbasierte PV-Zelle, d.h. die lichtsensitiven Areale 12 der ersten PV-Zelle 11 weisen ein perwoskitisches Material auf. Die zweite PV-Zelle 21 ist dagegen eine siliziumbasierte PV-Zelle. Perowskitische Materialien weisen einen größeren Bandabstand auf als siliziumbasierte Materialien, weswegen die perowskitbasierte PV-Zelle 11 einen höheren Absorptionsanteil im blauen bzw. kurzwelligen Spektralbereich hat und längerwelliges Licht durchlässt. Die siliziumbasierte PV-Zelle 21 absorbiert stärker im längerwelligen Spektralbereich, so dass das von der Perowskitzelle 11 durchgelassene Licht bzw. zumindest ein Teil davon von der Siliziumzelle 21 absorbiert werden kann.

Die PV-Einrichtung 100 weist eine Leistungselektronik 30 mit einer ersten Leistungselektronikeinheit 31 und einer zweiten Leistungselektronikeinheit 32 auf, wobei die Leistungselektronikeinheiten 31, 32 separat und unabhängig voneinander arbeiten. Die erste Leistungselektronikeinheit 31 ist der ersten PV-Zelle 11 zugeordnet und die zweite Leistungselektronikeinheit 32 ist der zweiten PV-Zelle 21 zugeordnet. Dabei bilden die erste PV-Zelle 11 und die erste Leistungselektronikeinheit 31 ein erstes PV-Subsystem 10 der Zellgruppe 1. Ebenso bilden die zweite PV-Zelle 21 und die zweite Leistungselektronikeinheit 32 ein zweites PV-Subsystem 20 der Zellgruppe 1. Die von den PV-Zellen 11, 21 bei Beleuchtung generierten Zellspannungen U1, U2 werden der jeweiligen Leistungselektronikeinheit 31, 32 über entsprechende elektrische Verbindungen 14, 24 zugeführt. In Abhängigkeit von einem jeweiligen Eingangswiderstand der Leistungselektronikeinheiten 31, 32 ergeben sich entsprechende Stromerträge I1, I2.

Die PV-Einrichtung 1 weist darüber hinaus eine Regeleinrichtung 40 auf, welche ausgebildet ist, um beim Betreiben der Leistungselektronikeinheit 31, 32 eines jeden PV-Subsystems 10, 20 die jeweilige Leistungselektronikeinheit 31, 32 derart zu regeln, dass ein Produkt aus dem Stromertrag I1 bzw. I2 und der Zellspannung U1 bzw. U2 der der jeweiligen Leistungselektronikeinheit 31, 32 zugeordneten PV-Zelle 11, 21 maximal ist. Dies führt dazu, dass der Energieertrag des jeweiligen PV-Subsystems 10, 20 maximal wird, wobei der wesentliche Punkt darin liegt, dass für die PV-Subsysteme 10, 20 individuell und unabhängig voneinander der optimale Arbeitspunkt angefahren wird.

In diesem Kontext und zur Erläuterung der Funktionsweise der Regeleinrichtung 40 zeigt die FIG 4 für eine typische PV-Zelle den Zusammenhang zwischen Stromertrag I und Zellspannung U bei konstanter Beleuchtung. Der optimale Arbeitspunkt mit maximalem Energieertrag bzw. optimaler Energieerzeugung liegt im Diagramm an dem mit MAX gekennzeichneten Punkt, bei dem das Produkt aus Zellspannung U und Stromertrag I maximal wird. Bei variablen Einsatzbedingungen, d.h. bspw. bei wechselnden Lichtverhältnissen, kommt es aufgrund der Verschiedenheit der PV-Zellen 11, 21 der Zellgruppe 1, welche typischerweise unterschiedlich auf Veränderungen von Lichtintensität und Temperatur etc. reagieren, zwangsläufig zu Situationen, in denen zumindest eine der PV-Zellen 11, 21 nicht mehr am optimalen Arbeitspunkt betrieben wird. Dies bedeutet für die gesamte Zellgruppe 1, dass sie als Ganzes nicht am optimalen Arbeitspunkt einsetzbar ist. Der Betrieb der Zellgruppe 1 am optimalen Arbeitspunkt ist nur dann möglich, wenn die einzelnen, die Zellgruppe 1 bildenden PV-Zellen 11, 21 bzw. die PV-Subsysteme 10, 20 jedes für sich am optimalen Arbeitspunkt betrieben wird. Um dies zu erreichen werden die separaten Leistungselektroniken 31, 32 eingesetzt, da deren individuelle, unabhängige Verwendung erlaubt, die Betriebsparameter für jede PV-Zelle 11, 21 bzw. für jedes PV-Subsystem 10, 20 individuell zu optimieren.

Die Regeleinrichtung 40 ist nun ausgebildet, um beim Regeln der jeweiligen Leistungselektronikeinheit 31, 32 einen Eingangswiderstand der jeweiligen Leistungselektronikeinheit 31, 32 und damit den Stromertrag I im jeweiligen PV-Subsystem 10, 20 derart anzupassen, dass das Produkt aus dem Stromertrag I1 bzw. I2 und der Zellspannung U1 bzw. U2 für die der jeweiligen Leistungselektronikeinheit 31, 32 zugeordnete PV-Zelle 11, 21 maximal ist, wobei die Regeleinrichtung 40 die Leistungselektronikeinheiten 31, 32 insbesondere unabhängig voneinander regelt. Hierzu kann die Regeleinrichtung 40 bspw. eine der Anzahl der PV-Subsysteme 10, 20 entsprechende Zahl von Reglern 41, 42 aufweisen, wobei jeder Leistungselektronikeinheit 31, 32 bzw. jedem PV-Subsystem 10, 20 ein Regler 41, 42 zugeordnet ist. Diese Regler 41, 42 können bspw. als sog. PID-Regler ausgebildet sein.

Die Regeleinrichtung 40 bzw. die einzelnen Regler 41, 42 arbeiten bspw. derart, dass für jedes PV-Subsystem 10, 20 separat dessen Stromertrag I1 bzw. I2 sowie die Zellspannung U1 bzw. U2 gemessen werden. Konkret kann bspw. der erste Regler 41 basierend auf den ihm zugeführten Werten für I1 und U1 den Eingangswiderstand der ersten Leistungselektronikeinheit 31 variieren und dabei den Stromertrag I1 sowie die Zellspannung U1 bzw. das Produkt aus diesen Messwerten überwachen. Der Eingangswiderstand wird dann derart eingestellt, dass wie bereits erwähnt das Produkt aus Stromertrag I1 und Zellspannung U1 maximal werden, einhergehend mit maximalem Energieertrag des ersten PV-Subsystems 10. Der Regler 42 des zweiten PV-Subsystems 42 arbeitet in gleicher Weise über die Variation der Eingangswiderstands der zweiten Leistungselektronikeinheit 32, so dass auch das Produkt aus Stromertrag I2 und Zellspannung U2 des zweite PV-Subsystems 20 maximal werden, einhergehend mit maximalem Energieertrag des zweiten PV-Subsystems 20. Über die mit Doppelpfeilen angedeuteten elektrischen Verbindungen 43, 44 zwischen Leistungselektronikeinheiten 31, 32 und Reglern 41, 42 wechselwirken also die miteinander verbundenen Komponenten 31, 41 bzw. 32, 42 dahingehend miteinander, dass den Reglern 41, 42 Strom- und Spannungswerte I1, I2, U1, U2 zur Verfügung gestellt werden und die Regler 41, 42 basierend auf diesen Werten die Leistungselektronikeinheiten 31, 32 insofern beeinflussen, als dass sie deren Eingangswiderstände regeln.

Die Regeleinrichtung 40 kann zusätzlich oder alternativ zur oben erläuterten, auf Strom- bzw. Spannungsmessungen basierenden Vorgehensweise mit Daten aus einer Sensoreinrichtung 50 gespeist werden. Die Sensoreinrichtung 50 weist eine Einrichtung 51 zur Ermittlung von Temperaturen der PV-Zellen 11, 21 und/oder zur Ermittlung einer Umgebungstemperatur der Tandem-PV-Zellgruppe 1 auf. Ein oder ggf. mehrere die Temperaturen und/oder die Umgebungstemperatur beschreibende Parameter werden der Regeleinrichtung 40 und den separaten Reglern 41, 42 als Eingangsgröße zugeführt. Alternativ oder zusätzlich kann die Sensoreinrichtung 50 eine Einrichtung 52 zur Ermittlung einer auf die Multi-PV-Zellgruppe 1 und insbesondere auf die erste PV-Zelle 11 fallenden Lichtstärke aufweisen, wobei ein die Lichtstärke beschreibender Parameter der Regeleinrichtung 40 bzw. den Reglern 41, 42 als Eingangsgröße zugeführt wird. Desweiteren kann die Sensoreinrichtung 50 eine Einrichtung 53 zur Ermittlung eines Spektrums eines auf die Multi-PV-Zellgruppe 1 und insbesondere auf die erste PV-Zelle 11 fallenden Lichts aufweisen, wobei ein das Spektrum beschreibender Parameter der Regeleinrichtung 40 bzw. den Reglern 41, 42 als Eingangsgröße zugeführt wird. Die Regeleinrichtung 40 ist nun ausgebildet, um basierend auf der oder den ihr zugeführten Eingangsgrößen die Leistungselektronikeinheiten 31, 32 derart zu regeln, dass das Produkt aus dem Stromertrag I und der Zellspannung U der der jeweiligen Leistungselektronikeinheit 31, 32 zugeordneten PV-Zelle 11, 21 maximal ist. Dies kann wieder durch entsprechende Anpassung des Eingangswiderstands der jeweiligen Leistungselektronikeinheit 31, 32 erfolgen. Die Zielwerte, auf die die Eingangswiderstände hierbei eingestellt werden, können bspw. modellbasiert ermittelt oder aber anhand von Lookup-Tabellen derart bestimmt werden, dass in Abhängigkeit von der oder den Eingangsgrößen für jede Leistungselektronikeinheit 31, 32 derjenige Eingangswiderstand aus einer entsprechenden Lookup-Tabelle bestimmt und eingestellt wird, dass das Produkt aus dem Stromertrag I und der Zellspannung U der der jeweiligen Leistungselektronikeinheit 31, 32 zugeordneten PV-Zelle 11, 21 maximal ist.

Darüber hinaus kann mit Hilfe der Regeleinrichtung 40 auch ein Alterungsprozess der Zellen 11, 21 beobachtet und ggf. berücksichtigt werden. Wenn in beiden Leistungselektronikeinheiten 31, 32 die Effektivität des Findens des optimalen Arbeitspunktes überwacht wird, kann eine Warnung über Degradation einer der Zellen abgegeben bzw. der Alterungszustand überwacht werden.

Generell gilt, dass Verschmutzung von Solarzellen insbesondere in ariden Wüstengebieten durch die Ablagerung von Staub auftritt, häufig noch durch salzhaltige Aerosole verstärkt. In feuchten und naturbelassenen Gebieten entsteht eine Verschmutzung durch die Ansiedlung von (grünen) Zellen und in Industriegebieten durch die Ablagerung von Partikeln, bspw. Ruß. Staubablagerungen sowie grüne Zellen weisen eine klar erkenntliche Farbe auf, verändern also die spektrale Zusammensetzung des Lichtes, welches die eigentlichen PV-Zellen erreicht. Im Falle von Rußablagerungen, welche auf den ersten Blick scheinbar farblos, d.h. im Wesentlichen schwarz sind, wird bei genauerer Betrachtung klar, dass auch die dunkel erscheinenden Rußpartikel eine spektral abhängige Lichtabsorption aufweisen. Bei einer mechanischen Veränderung der Oberfläche, bspw. Erzeugung einer matten Oberfläche durch Sandpartikel, erfolgt hingegen eine Streuung des Lichtes und nicht in erster Linie eine spektrale Verschiebung. Bei der aus einer Verschmutzung resultierenden Veränderung der spektralen Zusammensetzung des Lichtes erfolgt unausweichlich eine Verstimmung der Stromgeneration der beiden spektral unterschiedlichen PV-Einzelzellen 11, 21 der Tandemzelle 1. Die einzige Möglichkeit beiden Zellen 11, 21 nach wie vor trotz einer Verschmutzung stabil im Optimum betreiben zu können, ist die separate Ansteuerung beider Zellen bzw. die unabhängige, individuelle Regelung beider PV-Subsysteme 10, 20 nach dem oben beschriebenen Ansatz, bei dem für jedes Subsystem 10, 20 die jeweilige Leistungselektronikeinheit 31, 32 derart geregelt wird, dass das Produkt aus dem Stromertrag I und der Zellspannung U der der jeweiligen Leistungselektronikeinheit 31, 32 zugeordneten PV-Zelle 11, 21 maximal ist. Auch in dieser Anwendung, bei der eine Verschmutzung und in gleicher Weise eine eventuelle Alterung der PV-Zellen 11, 21 kompensiert werden kann, basiert die Regelung auf einer Einstellung des Eingangswiderstands einer jeweiligen Leistungselektronikeinheit 31, 32 dahingehend, dass das genannte Produkt maximal wird.

Der hier vorgeschlagene Ansatz eignet sich also zur Kompensation diverser Situationen bzw. Umgebungsbedingungen, wobei ein wesentlicher Punkt ist, dass die PV-Subsysteme 10, 20 bzw. die Leistungselektronikeinheiten 31,32 unabhängig voneinander geregelt werden.

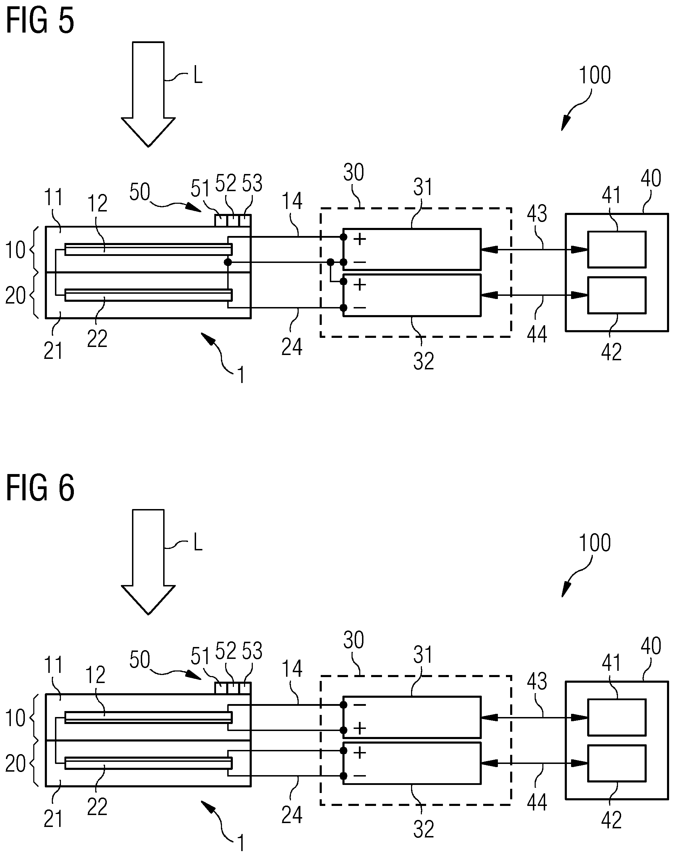

Die FIG 5 zeigt eine Ausführungsform der PV-Einrichtung 100, bei der der Verkabelungsaufwand zwischen Zellgruppe 1 und Leistungselektronik 40 reduziert ist. Hierzu werden die Zellen 11, 21 auf ein gemeinsames Potential gesetzt bzw. miteinander verbunden, so dass nur 3 elektrische Leitungen zur Leistungselektronik 40 geführt werden müssen.

Die in FIG 6 gezeigte Ausführungsform bewirkt, dass die insgesamt auftretenden Spannungen der Einzelzellen 11, 21 und damit die Anforderungen an die Isolation der Verkabelung minimiert werden kann. Hierzu werden die beiden Zellen 11, 21 derart angeordnet, dass ihre Spannungen U1, U2 einander entgegengerichtet sind. Dies ist bei herkömmlichen Tandem-PV-Zellgruppen naturgemäß nicht sinnvoll, kann hier jedoch vorteilhafterweise angewendet werden. Sinnvoll ist es optional wieder, wie in der in FIG 5 dargestellten Ausführung die einander gegenüber liegenden Anschlüsse der Zellen 11, 21 auf ein gemeinsames Potential zu legen.

## Patentansprüche

1. PV-Einrichtung (100) mit
- einer Multi-PV-Zellgruppe (1) mit zumindest einer ersten PV-Zelle (11) eines ersten Zelltyps und einer zweiten PV-Zelle (21) eines zweiten Zelltyps, wobei sich der erste und der zweite Zelltyp voneinander unterscheiden und wobei jede der PV-Zellen (11, 21) bei Lichteinfall auf die jeweilige PV-Zelle (11, 21) eine elektrische Zellspannung U1, U2 bereitstellt, **gekennzeichnet durch**
- eine Leistungselektronik (30) mit einer separaten ersten Leistungselektronikeinheit (31), die der ersten PV-Zelle (11) zugeordnet ist, und einer separaten zweiten Leistungselektronikeinheit (32), die der zweiten PV-Zelle (22) zugeordnet ist, wobei die in der jeweiligen PV-Zelle (11, 21) generierte elektrische Zellspannung U1, U2 und ein entsprechender Stromertrag I1, I2 der der jeweiligen PV-Zelle (11, 21) zugeordneten separaten Leistungselektronikeinheit (31, 32) zuführbar ist,
- eine Regeleinrichtung (40) zum Regeln der Leistungselektronik (30),
wobei
- die erste (31) und die zweite Leistungselektronikeinheit (32) mit Hilfe der Regeleinrichtung (40) unabhängig voneinander derart betreibbar sind, dass jedes PV-Subsystem (10, 20), welches jeweils eine der PV-Zellen (11, 21) und die der jeweiligen PV-Zelle (11, 21) zugeordnete Leistungselektronikeinheit (31, 32) aufweist, an seinem optimalen Arbeitspunkt arbeitet.

2. PV-Einrichtung (100) nach Anspruch 1, **dadurch gekennzeichnet, dass** die Regeleinrichtung (40) ausgebildet ist, um beim Betreiben der Leistungselektronikeinheit (31, 32) eines jeden PV-Subsystems (10, 20) die jeweilige Leistungselektronikeinheit (31, 32) derart zu regeln, dass ein Produkt aus dem Stromertrag I1, I2 und der Zellspannung U1, U2 der der jeweiligen Leistungselektronikeinheit (31, 32) zugeordneten PV-Zelle (11, 21) maximal ist.

3. PV-Einrichtung (100) nach Anspruch 2, **dadurch gekennzeichnet, dass** die Regeleinrichtung (40) ausgebildet ist, um beim Regeln der jeweiligen Leistungselektronikeinheit (31, 32) einen Eingangswiderstand der jeweiligen Leistungselektronikeinheit (31, 32) derart anzupassen, dass das Produkt aus dem Stromertrag I1, I2 und der Zellspannung U1, U2 der der jeweiligen Leistungselektronikeinheit (31, 32) zugeordneten PV-Zelle (11, 21) maximal ist.

4. PV-Einrichtung (100) nach einem der Ansprüche 1 bis 3, **gekennzeichnet durch** eine Sensoreinrichtung (50) aufweisend
- eine Einrichtung (51) zur Ermittlung von Temperaturen der PV-Zellen (11, 21) und/oder zur Ermittlung einer Umgebungstemperatur der Multi-PV-Zellgruppe (1), wobei ein oder mehrere die Temperaturen und/oder die Umgebungstemperatur beschreibende Parameter der Regeleinrichtung (40) als Eingangsgröße zugeführt werden, und/oder
- eine Einrichtung (52) zur Ermittlung einer auf die PV-Einrichtung (100), insbesondere auf die erste PV-Zelle (11), fallenden Lichtstärke, wobei ein die Lichtstärke beschreibender Parameter der Regeleinrichtung (40) als Eingangsgröße zugeführt wird, und/oder
- eine Einrichtung (53) zur Ermittlung eines Spektrums eines auf die PV-Einrichtung (100), insbesondere auf die erste PV-Zelle (11), fallenden Lichts, wobei ein das Spektrum beschreibender Parameter der Regeleinrichtung (40) als Eingangsgröße zugeführt wird,
wobei
- die Regeleinrichtung (40) ausgebildet ist, um die Leistungselektronikeinheiten (31, 32) basierend auf der oder den ihr zugeführten Eingangsgrößen zu regeln.

5. PV-Einrichtung (100) nach Anspruch 4, **dadurch gekennzeichnet, dass** die Regeleinrichtung (40) ausgebildet ist, um die Regelung, insbesondere basierend auf Lookup-Tabellen oder modellbasiert, derart auszuführen, dass in Abhängigkeit von der oder den Eingangsgrößen für jede Leistungselektronikeinheit (31, 32) derjenige Eingangswiderstand bestimmt und eingestellt wird, dass das Produkt aus dem Stromertrag I und der Zellspannung U der der jeweiligen Leistungselektronikeinheit (31, 32) zugeordneten PV-Zelle (11, 21) maximal ist.

6. PV-Einrichtung (100) nach einem der Ansprüche 1 bis 5, **dadurch gekennzeichnet, dass** der erste und der zweite Zelltyp derart ausgewählt sind, dass ihre PCE-Maxima in unterschiedlichen Spektralbereichen liegen.

7. PV-Einrichtung (100) nach einem der Ansprüche 1 bis 6, **dadurch gekennzeichnet, dass** die erste PV-Zelle (11) eine perowskitbasierte PV-Zelle ist und/oder die zweite PV-Zelle (21) eine siliziumbasierte PV-Zelle ist.

8. PV-Einrichtung (100) nach Anspruch 7, **dadurch gekennzeichnet, dass** die Regeleinrichtung (40) ausgebildet ist, um die der ersten, perowskitbasierten PV-Zelle (11) zugeordnete Leistungselektronikeinheit (31) derart zu regeln, dass eine Hysterese von Ausgangsgrößen der ersten PV-Zelle (11), insbesondere von Zellspannung U1 und Stromertrag I1, kompensiert werden.

9. PV-Einrichtung nach einem der Ansprüche 1 bis 8, **dadurch gekennzeichnet, dass** die Regeleinrichtung (40) ausgebildet ist, um die Regelung der Leistungselektronikeinheiten (31, 32) derart auszuführen, dass eine Alterung einer jeweiligen PV-Zelle (11, 21) und/oder eine Verschmutzung der Multi-PV-Zellgruppe (1) kompensiert werden.

10. Verfahren zum Betreiben einer PV-Einrichtung (100) mit
- einer Multi-PV-Zellgruppe (1) mit zumindest einer ersten PV-Zelle (11) eines ersten Zelltyps und einer zweiten PV-Zelle (21) eines zweiten Zelltyps, wobei sich der erste und der zweite Zelltyp voneinander unterscheiden und wobei jede der PV-Zellen (11, 21) bei Lichteinfall auf die jeweilige PV-Zelle /11, 21) eine elektrische Zellspannung U1, U2 bereitstellt,
- einer Leistungselektronik (30) mit einer separaten ersten Leistungselektronikeinheit (31), die der ersten PV-Zelle (11) zugeordnet ist, und einer separaten zweiten Leistungselektronikeinheit (32), die der zweiten PV-Zelle (22) zugeordnet ist, wobei die in der jeweiligen PV-Zelle (11, 21) generierte elektrische Zellspannung U1, U2 und ein entsprechender Stromertrag I1, I2 der der jeweiligen PV-Zelle (11, 21) zugeordneten separaten Leistungselektronikeinheit (31, 32) zugeführt werden,
- einer Regeleinrichtung (40) zum Regeln der Leistungselektronik (30),
wobei
- die erste (31) und die zweite Leistungselektronikeinheit (32) mit Hilfe der Regeleinrichtung (40) unabhängig voneinander derart betrieben werden, dass jedes PV-Subsystem (10, 20), welches jeweils eine der PV-Zellen (11, 21) und die der jeweiligen PV-Zelle (11, 21) zugeordnete Leistungselektronikeinheit (31, 32) aufweist, an seinem optimalen Arbeitspunkt arbeitet.

11. Verfahren nach Anspruch 10, **dadurch gekennzeichnet, dass** beim Betreiben der Leistungselektronikeinheit (31, 32) eines jeden PV-Subsystems (10, 20) die jeweilige Leistungselektronikeinheit (31, 32) derart geregelt wird, dass ein Produkt aus dem Stromertrag I1, I2 und der Zellspannung U1, U2 der der jeweiligen Leistungselektronikeinheit (31, 32) zugeordneten PV-Zelle (11, 21) maximal ist.

12. Verfahren nach Anspruch 11, **dadurch gekennzeichnet, dass** beim Regeln der jeweiligen Leistungselektronikeinheit (31, 32) ein Eingangswiderstand der jeweiligen Leistungselektronikeinheit (31, 32) derart angepasst wird, dass das Produkt aus dem Stromertrag I1, I2 und der Zellspannung U1, U2 der der jeweiligen Leistungselektronikeinheit (31, 32) zugeordneten PV-Zelle (11, 21) maximal ist.

13. Verfahren nach einem der Ansprüche 10 bis 12, wobei die PV-Einrichtung (100) eine Sensoreinrichtung (50) umfasst, aufweisend
- eine Einrichtung (51) zur Ermittlung von Temperaturen der PV-Zellen (11, 21) und/oder zur Ermittlung einer Umgebungstemperatur der Multi-PV-Zellgruppe (1), wobei ein oder mehrere die Temperaturen und/oder die Umgebungstemperatur beschreibende Parameter der Regeleinrichtung (40) als Eingangsgröße zugeführt werden, und/oder
- eine Einrichtung (52) zur Ermittlung einer auf die PV-Einrichtung (100), insbesondere auf die erste PV-Zelle (11), fallenden Lichtstärke, wobei ein die Lichtstärke beschreibender Parameter der Regeleinrichtung (40) als Eingangsgröße zugeführt wird, und/oder
- eine Einrichtung (53) zur Ermittlung eines Spektrums eines auf die PV-Einrichtung (100), insbesondere auf die erste PV-Zelle (11), fallenden Lichts, wobei ein das Spektrum beschreibender Parameter der Regeleinrichtung (40) als Eingangsgröße zugeführt wird,
wobei die Leistungselektronikeinheiten (31, 32) basierend auf der oder den der Regeleinrichtung (40) zugeführten Eingangsgrößen geregelt werden.

14. Verfahren nach Anspruch 13, **dadurch gekennzeichnet, dass** die Regelung, insbesondere basierend auf Lookup-Tabellen oder modellbasiert, derart ausgeführt wird, dass in Abhängigkeit von der oder den Eingangsgrößen für jede Leistungselektronikeinheit (31, 32) derjenige Eingangswiderstand bestimmt und eingestellt wird, dass das Produkt aus dem Stromertrag I und der Zellspannung U der der jeweiligen Leistungselektronikeinheit (31, 32) zugeordneten PV-Zelle (11, 21) maximal ist.

15. Verfahren nach einem der Ansprüche 10 bis 14, **dadurch gekennzeichnet, dass** die Leistungselektronikeinheiten (31, 32) derart geregelt werden, dass Einflüsse durch Alterung einer jeweiligen PV-Zelle und/oder Einflüsse durch eine Verschmutzung der Multi-PV-Zellgruppe (1) kompensiert werden.

## Claims

1. PV device (100) having
- a multi-PV cell group (1) having at least one first PV cell (11) of a first cell type and one second PV cell (21) of a second cell type, wherein the first and the second cell type differ from one another and wherein each of the PV cells (11, 21) provides an electric cell voltage U1, U2 under light incidence on the respective PV cell (11, 21), **characterized by**
- power electronics (30) having a separate first power electronics unit (31) that is assigned to the first PV cell (11) and a separate second power electronics unit (32) that is assigned to the second PV cell (22), wherein the electric cell voltage U1, U2 generated in the respective PV cell (11, 21) and a corresponding current yield I1, I2 are able to be fed to the separate power electronics unit (31, 32) assigned to the respective PV cell (11, 21),
- a control device (40) for controlling the power electronics (30),
wherein
- the first (31) and the second power electronics unit (32) are able to be operated independently of one another by way of the control device (40) such that each PV subsystem (10, 20), each of which has one of the PV cells (11, 21) and the power electronics unit (31, 32) assigned to the respective PV cell (11, 21), operates at its optimum operating point.

2. PV device (100) according to Claim 1, **characterized in that** the control device (40) is designed, during operation of the power electronics unit (31, 32) of each PV subsystem (10, 20), to control the respective power electronics unit (31, 32) such that a product of the current yield I1, I2 and the cell voltage U1, U2 of the PV cell (11, 21) assigned to the respective power electronics unit (31, 32) is at a maximum.

3. PV device (100) according to Claim 2, **characterized in that** the control device (40) is designed, during the controlling of the respective power electronics unit (31, 32), to adjust an input resistance of the respective power electronics unit (31, 32) such that the product of the current yield I1, I2 and the cell voltage U1, U2 of the PV cell (11, 21) assigned to the respective power electronics unit (31, 32) is at a maximum.

4. PV device (100) according to one of Claims 1 to 3, **characterized by** a sensor device (50) having
- a device (51) for determining temperatures of the PV cells (11, 21) and/or for determining an ambient temperature of the multi-PV cell group (1), wherein one or more parameters describing the temperatures and/or the ambient temperature are fed to the control device (40) as input variable, and/or
- a device (52) for determining a light intensity incident on the PV device (100), in particular on the first PV cell (11), wherein a parameter describing the light intensity is fed to the control device (40) as input variable, and/or
- a device (53) for determining a spectrum of a light incident on the PV device (100), in particular on the first PV cell (11), wherein a parameter describing the spectrum is fed to the control device (40) as input variable,
wherein
- the control device (40) is designed to control the power electronics units (31, 32) based on the input variable or input variables fed thereto.

5. PV device (100) according to Claim 4, **characterized in that** the control device (40) is designed to perform the control, in particular based on lookup tables or in a model-based manner, such that, depending on the input variable or input variables for each power electronics unit (31, 32), that input resistance is determined and set such that the product of the current yield I and the cell voltage U of the PV cell (11, 21) assigned to the respective power electronics unit (31, 32) is at a maximum.

6. PV device (100) according to one of Claims 1 to 5, **characterized in that** the first and the second cell type are selected such that their PCE maxima lie in different spectral ranges.

7. PV device (100) according to one of Claims 1 to 6, **characterized in that** the first PV cell (11) is a perovskite-based PV cell and/or the second PV cell (21) is a silicon-based PV cell.

8. PV device (100) according to Claim 7, **characterized in that** the control device (40) is designed to control the power electronics unit (31) assigned to the first perovskite-based PV cell (11) such that hysteresis of output variables of the first PV cell (11), in particular of cell voltage U1 and current yield I1, is compensated.

9. PV device according to one of Claims 1 to 8, **characterized in that** the control device (40) is designed to execute the control of the power electronics units (31, 32) such that aging of a respective PV cell (11, 21) and/or soiling of the multi-PV cell group (1) is compensated.

10. Method for operating a PV device (100) having
- a multi-PV cell group (1) having at least one first PV cell (11) of a first cell type and one second PV cell (21) of a second cell type, wherein the first and the second cell type differ from one another and wherein each of the PV cells (11, 21) provides an electric cell voltage U1, U2 under light incidence on the respective PV cell (11, 21),
- power electronics (30) having a separate first power electronics unit (31) that is assigned to the first PV cell (11) and a separate second power electronics unit (32) that is assigned to the second PV cell (22), wherein the electric cell voltage U1, U2 generated in the respective PV cell (11, 21) and a corresponding current yield I1, I2 are fed to the separate power electronics unit (31, 32) assigned to the respective PV cell (11, 21),
- a control device (40) for controlling the power electronics (30),
wherein
- the first (31) and the second power electronics unit (32) are operated independently of one another by way of the control device (40) such that each PV subsystem (10, 20), each of which has one of the PV cells (11, 21) and the power electronics unit (31, 32) assigned to the respective PV cell (11, 21), operates at its optimum operating point.

11. Method according to Claim 10, **characterized in that**, during the operation of the power electronics unit (31, 32) of each PV subsystem (10, 20), the respective power electronics unit (31, 32) is controlled such that a product of the current yield I1, I2 and the cell voltage U1, U2 of the PV cell (11, 21) assigned to the respective power electronics unit (31, 32) is at a maximum.

12. Method according to Claim 11, **characterized in that**, during the control of the respective power electronics unit (31, 32), an input resistance of the respective power electronics unit (31, 32) is adjusted such that the product of the current yield I1, I2 and the cell voltage U1, U2 of the PV cell (11, 21) assigned to the respective power electronics unit (31, 32) is at a maximum.

13. Method according to one of Claims 10 to 12, wherein the PV device (100) has a sensor device (50), having
- a device (51) for determining temperatures of the PV cells (11, 21) and/or for determining an ambient temperature of the multi-PV cell group (1), wherein one or more parameters describing the temperatures and/or the ambient temperature are fed to the control device (40) as input variable, and/or
- a device (52) for determining a light intensity incident on the PV device (100), in particular on the first PV cell (11), wherein a parameter describing the light intensity is fed to the control device (40) as input variable, and/or
- a device (53) for determining a spectrum of a light incident on the PV device (100), in particular on the first PV cell (11), wherein a parameter describing the spectrum is fed to the control device (40) as input variable,
wherein the power electronics units (31, 32) are controlled based on the input variable or input variables fed to the control device (40).

14. Method according to Claim 13, **characterized in that** the control is executed, in particular based on lookup tables or in a model-based manner, such that, depending on the input variable or input variables for each power electronics unit (31, 32), that input resistance is determined and set such that the product of the current yield I and the cell voltage U of the PV cell (11, 21) assigned to the respective power electronics unit (31, 32) is at a maximum.

15. Method according to one of Claims 10 to 14, **characterized in that** the power electronics units (31, 32) are controlled such that influences caused by aging of a respective PV cell and/or influences caused by soiling of the multi-PV cell group (1) are compensated.

## Revendications

1. Dispositif (100) PV comprenant
- un groupe (1) à multi-cellules PV comprenant au moins une première cellule (11) PV d'un premier type et une deuxième cellule (21) PV d'un deuxième type, le premier et le deuxième type étant différent l'un de l'autre et chacune des cellules (11, 21) PV donnant à l'incidence de lumière sur la cellule (11, 21) PV respective une tension U1, U2 électrique de cellule,
- **caractérisé par** une électronique (30) de puissance ayant une première unité (31) électronique de puissance distincte, qui est associée à la première cellule (11) PV, et une deuxième unité (32) électronique de puissance distincte, qui est associée à la deuxième cellule (22) PV, la tension U1, U2 électrique de cellule produite dans la cellule (11, 21) PV respective et une production I1, I2 de courant correspondante pouvant être envoyée à l'unité (31, 32) électronique de puissance distincte associée à la cellule (11, 21) PV respective,
- un dispositif (40) de régulation pour réguler l'électronique (30) de puissance, dans lequel
- la première (31) et la deuxième unité (32) électronique de puissance peuvent fonctionner indépendamment l'une de l'autre à l'aide du dispositif (40) de régulation de manière à ce que chaque sous-système (10, 20) PV, qui a respectivement l'une des cellules (11, 21) PV et l'unité (31, 32) électronique de puissance associée à la cellule (11, 21) PV respective, fonctionne à son point de fonctionnement optimum.

2. Dispositif (100) PV suivant la revendication 1, **caractérisé en ce que** le dispositif (40) de régulation est constitué pour, lors du fonctionnement de l'unité (31, 32) électronique de puissance de l'un de chaque sous-système (10, 20) PV, réguler l'unité (31, 32) électronique de puissance respective de manière à ce que le produit de la production I1, I2 de courant par la tension U1, U2 de cellule de la cellule (11, 21) PV associée à l'unité (31, 32) électronique de puissance respective soit maximum.

3. Dispositif (100) PV suivant la revendication 2, **caractérisé en ce que** le dispositif (40) de régulation est constitué pour adapter, lors de la régulation de l'unité (31, 32) électronique de puissance respective, une résistance d'entrée de l'unité (31, 32) électronique de puissance respective de manière à ce que le produit de la production I1, I2 de courant par la tension U1, U2 de cellule de la cellule (11, 21) PV associée à l'unité (31, 32) électronique de puissance respective soit maximum.

4. Dispositif (100) PV suivant l'une des revendications 1 à 3, **caractérisé par** un dispositif (50) capteur comportant
- un dispositif (51) de détermination de température des cellules (11, 21) PV et/ou de détermination d'une température ambiante du groupe (1) de multi-cellules PV, dans lequel on envoie comme grandeur d'entrée au dispositif (40) de régulation un ou plusieurs paramètres décrivant les températures et/ou la température ambiante et/ou
- un dispositif (52) de détermination d'une intensité lumineuse incidente sur le dispositif (100) PV, notamment sur la première cellule (11) PV, un paramètre décrivant l'intensité lumineuse étant envoyé comme grandeur d'entrée au dispositif (40) de régulation et/ou
- un dispositif (53) de détermination d'un spectre d'une lumière incidente sur le dispositif (100) PV, notamment sur la première cellule (11) PV, un paramètre décrivant le spectre étant envoyé comme grandeur d'entrée au dispositif (40) de régulation,
dans lequel
- le dispositif (40) de régulation est constitué pour réguler les unités (31, 32) électroniques de puissance sur la base de la ou des grandeurs d'entrée qui leur sont envoyées.

5. Dispositif (100) PV suivant la revendication 4, **caractérisé en ce que** le dispositif (40) de régulation est constitué pour effectuer la régulation, notamment sur la base de tables de lookup ou sur la base d'un modèle de manière à déterminer et à régler en fonction de la ou des grandeurs d'entrée pour chaque unité (31, 32) électronique de puissance la résistance d'entrée qui rend maximum le produit de la production I de courant par la tension U de cellule de la cellule (11, 21) PV associée à l'unité (31, 32) électronique de puissance respective.

6. Dispositif (100) suivant l'une des revendications 1 à 5, **caractérisé en ce que** le premier et le deuxième types de cellule sont choisis de manière à ce que leurs maximums PCE soient dans des domaines spectraux différents.

7. Dispositif (100) suivant l'une des revendications 1 à 6, **caractérisé en ce que** la première cellule (11) PV est une cellule PV à base de pérovskite et/ou **en ce que** la deuxième cellule (21) PV est une cellule PV à base de silicium.

8. Dispositif (100) suivant la revendication 7, **caractérisé en ce que** le dispositif (40) de régulation est constitué pour réguler l'unité (31) électronique de puissance associée à la première cellule (11) PV à base de pérovskite de manière à compenser une hystérésis de grandeur de sortie de la première cellule (11) PV, notamment de la tension U1 de la cellule et de la production I1 de courant.

9. Dispositif (100) suivant l'une des revendications 1 à 8, **caractérisé en ce que** le dispositif (40) de régulation est constitué pour effectuer la régulation des unités (31, 32) électroniques de puissance de manière à compenser un vieillissement d'une cellule (11, 21) PV respective et/ou une encrassement du groupe (1) de multi-cellules PV.

10. Procédé pour faire fonctionner un dispositif PV comprenant
- un groupe (1) à multi-cellules PV comprenant au moins une première cellule (11) PV d'un premier type et une deuxième cellule (21) PV d'un deuxième type, le premier et le deuxième type étant différent l'un de l'autre et chacune des cellules (11, 21) PV donnant à l'incidence de lumière sur la cellule (11, 21) PV respective une tension U1, U2 électrique de cellule,
- une électronique (30) de puissance ayant une première unité (31) d'électronique de puissance distincte, qui est associée à la première cellule (11) PV, et une deuxième unité (32) électronique de puissance distincte, qui est associée à la deuxième cellule (22) PV, dans lequel on envoie la tension U1, U2 électrique de cellule produite dans la cellule (11, 21) PV respective et une production I1, I2 de courant correspondante à l'unité (31, 32) électronique de puissance distincte associée à la cellule (11, 21) PV respective,
- un dispositif (40) de régulation pour réguler l'électronique (30) de puissance dans lequel
- on fait fonctionner la première (31) et la deuxième unité (32) électronique de puissance à l'aide du dispositif (40) de régulation indépendamment l'une de l'autre de manière à ce que chaque sous-système (10, 20) PV, qui a respectivement l'une des cellules (11, 21) PV et l'unité (31, 32) électronique de puissance associée à la cellule (11, 21) PV respective, fonctionne à son point de fonctionnement optimum.

11. Procédé suivant la revendication 10, **caractérisé en ce que** lors du fonctionnement de l'unité (31, 32) électronique de puissance de chaque sous-système (10, 20) PV, on régule l'unité (31, 32) électronique de puissance respective de manière à ce que le produit de la production I1, I2 de courant par la tension U1, U2 de cellule de la cellule (11, 21) PV associée à l'unité (31, 32) électronique de puissance respective soit maximum.

12. Procédé suivant la revendication 11, **caractérisé en ce que**, lors de la régulation de l'unité (31, 32) électronique de puissance respective, on adapte une résistance d'entrée de l'unité (31, 32) électronique de puissance respective de manière à ce que le produit de la production I1, I2 de courant par la tension U1, U2 de cellule de la cellule (11, 21) PV associée à l'unité (31, 32) électronique de puissance respective soit maximum.

13. Procédé suivant l'une des revendications 10 à 12, dans lequel le dispositif (100) PV comprend un dispositif (50) de capteur, comportant
- un dispositif (51) de détermination de température des cellules (11, 21) PV et/ou de détermination d'une température ambiante du groupe (1) de multi-cellules PV, dans lequel on envoie comme grandeur d'entrée au dispositif (40) de régulation un ou plusieurs paramètres décrivant les températures et/ou la température ambiante et/ou
- un dispositif (52) de détermination d'une intensité lumineuse incidente sur le dispositif (100) PV, notamment sur la première cellule (11) PV, un paramètre décrivant l'intensité lumineuse étant envoyé comme grandeur d'entrée au dispositif (40) de régulation et/ou
- un dispositif (53) de détermination d'un spectre d'une lumière incidente sur le dispositif (100) PV, notamment sur la première cellule (11) PV, un paramètre décrivant le spectre étant envoyé comme grandeur d'entrée au dispositif (40) de régulation,
dans lequel on régule les unités (31, 32) électroniques de puissance sur la base de la ou des grandeurs d'entrée envoyées au dispositif (40) de régulation.

14. Procédé suivant la revendication 13, **caractérisé en ce que** l'on effectue la régulation, notamment sur la base de tables de lookup ou sur la base d'un modèle, de manière à déterminer et à régler en fonction de la ou des grandeurs d'entrée pour chaque unité (31, 32) électronique de puissance la résistance d'entrée qui rend maximum le produit de la production I de courant par la tension U de cellule de la cellule (11, 21) PV associée à l'unité (31, 32) électronique de puissance respective.

15. Procédé suivant l'une des revendications 10 à 14, **caractérisé en ce que** l'on régule les unités (31, 32) électroniques de puissance de manière à compenser des influences par vieillissement d'une cellule PV respective et/ou des influences par une encrassement du groupe (1) de multi-cellules PV.
